# DEMANDE DE BREVET EUROPEEN

(11) **EP 2 317 519 A1**
(43) Date de publication de la demande: **04.05.2011**
(21) Numéro de dépôt: 10009123.0
(22) Date de dépôt: 02.09.2010
(51) Int. Cl.: G11C 16/30, G11C 16/06, G11C 16/14

(54) **Circuit intégré comprenant une borne non dédié de réception d'une haute tension d'effacement programmation**

(30) Priorité: 20.10.2009 FR 0905025; 20.10.2009 FR 0905026
(71) Demandeur: STMicroelectronics Rousset SAS, 13790 Rousset (FR)
(72) Inventeur: Tailliet, François, 13710 Fuveau (FR)
(74) Mandataire: Marchand, André

(57) **Abrégé**

L'invention concerne un circuit intégré (IC2) alimenté électriquement par une tension d'alimentation (Vdd) et comprenant une mémoire (MEM2) effaçable et/ou programmable électriquement au moyen d'une seconde tension (HV, Vpp) supérieure à la tension d'alimentation (Vdd). Le circuit intégré comprend des moyens (WPP, TSCT, CMP, LSCT) pour recevoir la seconde tension (HV, Vpp) par l'intermédiaire d'une borne (P1) de réception de la tension d'alimentation (Vdd) ou par l'intermédiaire d'une borne (P2, P3) de réception ou d'émission d'un signal de données ou d'horloge (S1, S2). Application notamment à la réalisation d'étiquettes électroniques comportant un nombre réduit de bornes d'interconnexion.

## Description

La présente invention concerne un circuit intégré à mémoire comprenant une mémoire effaçable et/ou programmable électriquement au moyen d'une seconde tension supérieure à la tension d'alimentation.

La présente invention concerne également un dispositif pour fournir une haute tension d'effacement programmation à un circuit intégré.

Sur le marché des circuits intégrés à mémoire, il existe actuellement une demande pour des circuits intégrés programmables à très bas coût, de très faible encombrement et ayant un nombre de bornes d'interconnexion minimal (plages de contact). De tels circuits intégrés offrent généralement une mémoire de taille limitée, parfois de quelques dizaines ou centaines de bits. Ils peuvent être reprogrammables par l'utilisateur, ou être programmés en usine une fois pour toutes. La mémoire est généralement du type effaçable et programmable électriquement (EEPROM).

Il existe en effet de nombreuses applications pour de tels circuits intégrés à mémoire, comme la réalisation d'étiquettes électroniques ("tags") contenant un numéro de série programmé en usine, la réalisation de circuits de calibration de composants divers (capteurs, éclairages à diode DEL,...) contenant des données de calibration programmées en usine et éventuellement reprogrammables en cours d'utilisation, etc.

Pour écrire des données dans leur mémoire, de tels circuits intégrés ont besoin d'une tension d'effacement programmation de forte valeur, classiquement comprise entre 10V et 15V, nettement supérieure à leur tension d'alimentation, de l'ordre de 3 à 5 V.

Dans les années 1980-1990, cette haute tension d'effacement programmation était fournie aux circuits intégrés par l'intermédiaire d'une borne de connexion dédiée. Cette borne de connexion fut ensuite supprimée et remplacée par une pompe de charge embarquée, capable de fournir la tension d'effacement programmation à partir de la tension d'alimentation des circuits intégrés. Il n'est plus envisageable à l'heure actuelle de revenir à cette solution ancienne, car l'ajout d'une telle borne de connexion serait contraire à l'exigence actuelle de réduction du nombre de bornes de connexion des circuits intégrés.

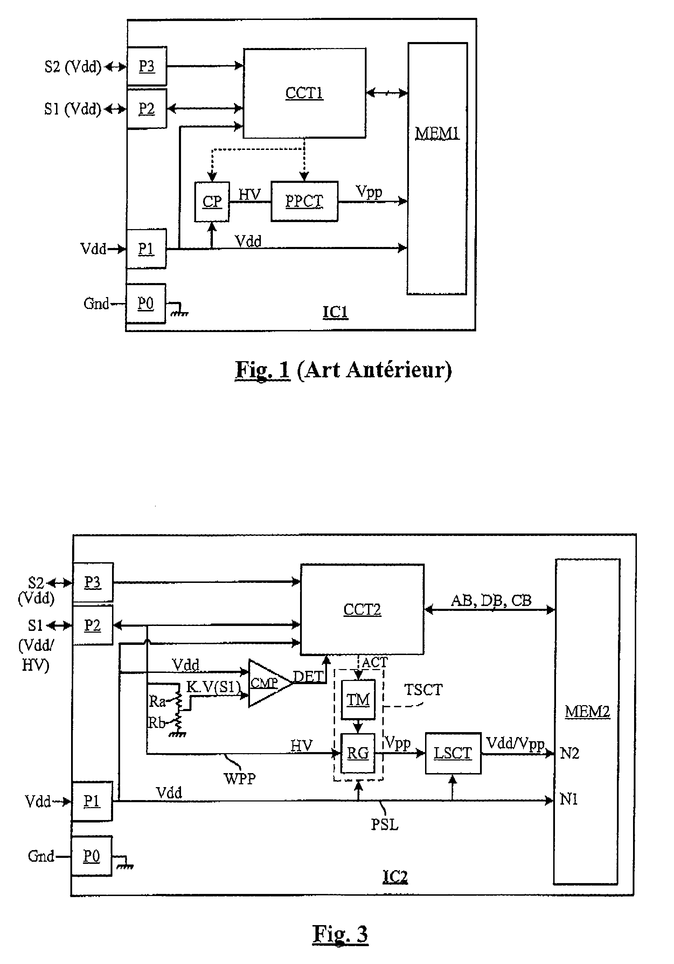

L'architecture d'un circuit intégré classique du type considéré ici est représentée schématiquement sur la figure 1. Le circuit intégré IC1 comprend une mémoire MEM1 de type EEPROM, un circuit de contrôle CCT1, une pompe de charges CP, un circuit PPCT, une borne de masse P0 (GND), une borne P1 recevant une tension d'alimentation Vdd, une borne de connexion P2 pour recevoir et/ou émettre un signal de données ou d'horloge S1, et une borne de connexion P3 pour recevoir ou émettre un signal de données ou d'horloge S2.

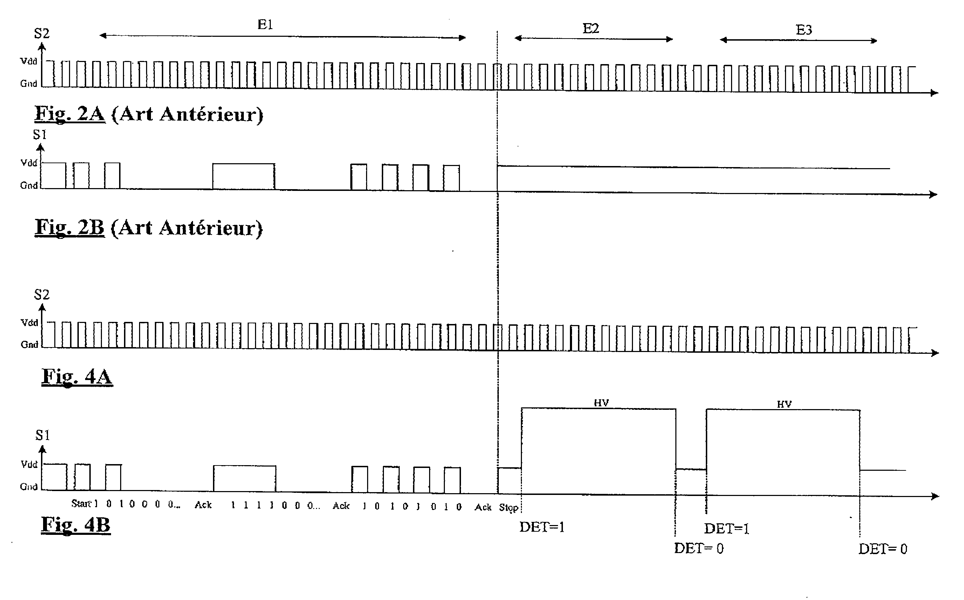

Le circuit de contrôle CCT1 est configuré pour exécuter des commandes de lecture ou d'écriture de la mémoire reçues par l'intermédiaire des bornes P2, P3. A titre d'exemple, les figures 2A, 2B représentent la forme des signaux S1, S2 lors de la réception d'une commande d'écriture via un bus I2C. Le signal S1 est dans ce cas le signal de données "SDA" ("Serial DAta") prévu par le protocole I2C et le signal S2 est le signal d'horloge "SCL" ("Serial CLock") prévu par ce protocole.

La commande est reçue au cours d'une phase E1, par l'intermédiaire du signal S1 qui véhicule des bits à 1 et à 0. Le circuit CCT1 déclenche ensuite une phase E2 d'effacement d'une zone cible de la mémoire désignée par la commande, puis une phase E3 de programmation de cellules mémoire dans la zone cible effacée. A cet effet, le circuit CCT1 active la pompe de charge CP et le circuit PPCT. La pompe de charge CP fournit une haute tension HV au circuit PPCT. Ce dernier met en forme cette haute tension HV et fournit à la mémoire MEM1 une haute tension Vpp d'effacement programmation d'amplitude régulée et de durée contrôlée, par exemple une rampe de tension suivie d'un plateau de tension de valeur proche de la tension HV. Le signal rampe-plateau peut être fourni deux fois à la mémoire, d'abord pendant la phase E1 et ensuite pendant la phase E2.

La prévision d'une pompe de charges embarquée représente toutefois un handicap en termes de prix de revient et de surface de silicium occupée par le circuit intégré. Une pompe de charge nécessite plusieurs condensateurs de l'ordre de quelques pF chacun, occupant une surface de silicium non négligeable. La régulation de la tension HV au moyen du circuit PPCT, pour obtenir la tension Vpp, nécessite par ailleurs une référence de tension stable et une circuiterie spécifique qui occupe une surface de silicium non négligeable.

Ainsi, il peut être souhaité de simplifier la structure d'un circuit intégré à mémoire nécessitant une haute tension d'effacement programmation pour écrire des données dans sa mémoire.

Indépendamment de cela, il peut également être souhaité de prévoir un dispositif pour fournir une haute tension d'effacement programmation à un ou plusieurs circuits intégrés.

Des modes de réalisation de l'invention concernent un circuit intégré à mémoire alimenté électriquement par une tension d'alimentation et comprenant une mémoire effaçable et/ou programmable électriquement au moyen d'une seconde tension supérieure à la tension d'alimentation, comprenant des moyens pour recevoir la seconde tension par l'intermédiaire d'une borne de réception de la tension d'alimentation ou par l'intermédiaire d'une borne de réception ou d'émission d'un signal de données ou d'horloge.

Selon un mode de réalisation, le circuit intégré comprend des moyens pour recevoir la seconde tension par l'intermédiaire d'une borne de réception de la tension d'alimentation, et un circuit régulateur limiteur de tension ayant une entrée reliée à la borne de réception de tension d'alimentation et fournissant la tension d'alimentation lorsque la seconde tension est présente sur la borne de réception.

Selon un mode de réalisation, le circuit intégré comprend des moyens pour recevoir la seconde tension par l'intermédiaire d'une borne de réception ou d'émission d'un signal de données, et un circuit de découplage ayant une entrée reliée à la borne de réception ou d'émission du signal de données et une sortie reliée à un noeud d'alimentation du circuit intégré destiné à recevoir la seconde tension, le circuit de découplage étant configuré pour empêcher les fluctuations du signal de données d'atteindre le noeud d'alimentation, et pour transférer la seconde tension au noeud d'alimentation lorsqu'elle est présente sur la borne de réception ou d'émission du signal de données.

Selon un mode de réalisation, le circuit intégré comprend des moyens pour recevoir la seconde tension par l'intermédiaire d'une borne de réception d'un signal d'horloge, et un circuit de redressement ayant une entrée reliée à la borne de réception de signal d'horloge et une sortie reliée à un noeud d'alimentation du circuit intégré, pour fournir la seconde tension au noeud d'alimentation lorsqu'elle est présente sur la borne de réception de signal d'horloge.

Selon un mode de réalisation, le circuit intégré comprend également des moyens pour recevoir la tension d'alimentation par l'intermédiaire d'une borne de réception d'un signal de données ou d'horloge.

Selon un mode de réalisation, le circuit intégré est configuré pour appliquer la seconde tension à la mémoire sans contrôler la durée ni la forme de la seconde tension.

Selon un mode de réalisation, le circuit intégré comprend un circuit élévateur de tension comprenant une première entrée recevant la tension d'alimentation, une seconde entrée recevant la seconde tension, et une sortie fournissant la seconde tension à la mémoire lorsque celle-ci est présente sur la seconde entrée, sinon fournissant la tension d'alimentation.

Selon un mode de réalisation, le circuit intégré comprend un circuit de contrôle configuré pour exécuter des commandes d'effacement et/ou de programmation de la mémoire, et un circuit de détection de la présence de la seconde tension, fournissant un signal de détection au circuit de contrôle pour la synchronisation du circuit de contrôle relativement à l'apparition de la seconde tension.

Des modes de réalisation de l'invention concernent également un système électronique comprenant au moins un circuit intégré à mémoire alimenté électriquement par une tension d'alimentation et comprenant une mémoire effaçable et/ou programmable électriquement au moyen d'une seconde tension supérieure à la tension d'alimentation, un bus de données connecté au circuit intégré à mémoire. Le système comprend des moyens pour appliquer la seconde tension au circuit intégré par l'intermédiaire d'un fil du bus de données qui est connecté à une borne de réception de la tension d'alimentation du circuit intégré ou à une borne de réception ou d'émission d'un signal de données ou d'horloge du circuit intégré.

Selon un mode de réalisation, les moyens pour appliquer la seconde tension comprennent un dispositif de gestion de tension connecté audit fil du bus de données et agencé pour surveiller les communications sur le bus de données et détecter le fait qu'une commande d'écriture a été appliquée au circuit intégré, et appliquer la seconde tension sur ledit fil du bus de données lorsque la commande d'écriture a été détectée.

Des modes de réalisation de l'invention concernent également un procédé pour écrire des données dans un circuit intégré à mémoire alimenté électriquement par une tension d'alimentation et comprenant une mémoire effaçable et/ou programmable électriquement au moyen d'une seconde tension supérieure à la tension d'alimentation. Le procédé comprend les étapes consistant à appliquer une commande d'écriture au circuit intégré, puis fournir la seconde tension au circuit intégré par l'intermédiaire d'une borne de réception de la tension d'alimentation ou par l'intermédiaire d'une borne de réception ou d'émission d'un signal de données ou d'horloge du circuit intégré.

Selon un mode de réalisation, le procédé comprend les étapes consistant à connecter le circuit intégré à un bus de données et connecter un fil du bus de données à une borne de réception de la tension d'alimentation ou à une borne de réception ou d'émission d'un signal de données ou d'horloge du circuit intégré, appliquer la commande d'écriture au circuit intégré par l'intermédiaire du bus de données, et fournir la seconde tension au circuit intégré par l'intermédiaire dudit fil du bus de données.

Selon un mode de réalisation, le procédé comprend les étapes consistant à appliquer la commande d'écriture au circuit intégré au moyen d'un circuit maître connecté au bus de données, détecter l'application de la commande d'écriture au moyen d'un dispositif de gestion de tension connecté au bus de données, distinct du circuit maître et agencé pour surveiller les données circulant sur le bus, et appliquer la seconde tension audit fil du bus de données au moyen du dispositif de gestion de tension.

Ces différents aspects de la présente invention seront mieux compris à la lecture de la description suivante de modes de réalisation de l'invention, faite à titre non limitatif en référence aux dessins annexés parmi lesquels :
- la figure 1 précédemment décrite représente un circuit intégré à mémoire classique,
- les figures 2A, 2B précédemment décrites représentent des signaux de données et d'horloge reçus par le circuit intégré en relation avec la réception d'une commande d'écriture de données,
- la figure 3 représente un mode de réalisation d'un circuit intégré à mémoire selon l'invention,
- les figures 4A, 4B représentent des signaux de données et d'horloge et une haute tension reçus par le circuit intégré de la figure 3 en relation avec la réception et l'exécution d'une commande d'écriture de données,
- la figure 5 est le schéma électrique d'un mode de réalisation d'un circuit à décalage de tension représenté sous forme de bloc sur la figure 3,
- la figure 6 représente un autre mode de réalisation d'un circuit intégré à mémoire selon l'invention,
- la figure 7 représente un signal de données et une haute tension reçus par le circuit intégré de la figure 6 en relation avec la réception et l'exécution d'une commande d'écriture,
- la figure 8 est le schéma électrique d'un mode de réalisation d'un circuit de découplage représenté sous forme de bloc sur la figure 6,
- la figure 9 représente un autre mode de réalisation d'un circuit intégré à mémoire selon l'invention,
- la figure 10 est le schéma électrique d'un mode de réalisation d'un régulateur de tension représenté sous forme de bloc sur la figure 9,
- la figure 11 représente un système électronique comprenant des circuits intégrés selon l'invention et un dispositif de gestion de tension selon l'invention,
- la figure 12 représente une variante de réalisation du système électronique représenté sur la figure 11,
- la figure 13 représente un mode de réalisation d'une mémoire représentée sous forme de bloc sur les figures 3, 6 et 9, et
- la figure 14 représente un mode de réalisation d'une cellule mémoire de la mémoire de la figure 13.

### Premier mode de réalisation

La figure 3 représente un premier mode de réalisation d'un circuit intégré à mémoire IC2 selon l'invention. Le circuit intégré IC2 comprend des bornes de connexion P0, P1, P2, P3, une mémoire MEM2, un circuit de contrôle CCT2, un circuit minuteur-séquenceur TSCT et un circuit élévateur de tension LSCT ("Level Shifter"). La borne P0 est une borne de connexion de masse (GND). La borne P1 est une borne d'alimentation reliée à une ligne d'alimentation interne PSL du circuit intégré, et reçoit une tension d'alimentation Vdd. Les bornes P2, P3 sont des bornes de communication permettant au circuit intégré de recevoir ou d'émettre des signaux de données ou d'horloge S1(Vdd), S2(Vdd) dont la tension maximale n'excède généralement pas la tension Vdd dans des conditions normales de fonctionnement.

Le circuit minuteur-séquenceur TSCT est prévu pour recevoir une haute tension HV à l'état brut et la transformer en une tension Vpp d'effacement programmation de la mémoire MEM2 de forme et de durée contrôlée. Le circuit TSCT comprend par exemple un circuit générateur de rampe RG et une minuterie TM ("timer"). Le circuit RG fournit une tension comprenant une rampe de tension suivie d'un plateau de tension Vpp de valeur régulée. La minuterie TM ("timer") désactive le circuit RG et remet la tension Vpp à zéro lorsqu'un laps de temps déterminé est écoulé.

Le circuit élévateur de tension LSCT comprend une première entrée connectée à la sortie du circuit TSCT, recevant la tension Vpp, une seconde entrée connectée à la ligne d'alimentation PSL, recevant la tension Vdd, et une sortie fournissant la tension Vpp ou la tension Vdd en l'absence de la tension Vpp.

La mémoire MEM2 est par exemple une mémoire effaçable et programmable électriquement EEPROM. Elle présente un noeud d'alimentation N1 prévu pour recevoir la tension Vdd et un noeud d'alimentation N2 prévu pour recevoir la tension Vpp ou la tension Vdd en l'absence de la tension Vpp. Le noeud N1 est connecté à la ligne d'alimentation PSL tandis que le noeud N2 est connecté à la sortie du circuit élévateur de tension LSCT.

Le circuit CCT2 assure la gestion d'un protocole de communication pour l'échange de données via un bus de données connecté aux bornes P2, P3 (non représenté). Il assure également le décodage et l'exécution de commandes de lecture et d'écriture de la mémoire MEM reçues par l'intermédiaire des bornes P2, P3. Le circuit CCT2 peut être réalisé sous forme de machine d'état à logique câblée ("state machine"), de circuit microprogrammé, de microprocesseur, etc. On supposera dans ce qui suit que le circuit CCT2 est configuré pour recevoir les commandes de lecture ou d'écriture de la mémoire via un bus I2C connecté aux bornes P2, P3.

Selon l'invention, le circuit intégré IC2 est dépourvu de pompe de charges ou autre moyen permettant de générer la haute tension HV partir de la tension d'alimentation Vdd, et reçoit la haute tension HV par l'intermédiaire de la borne P2. Ainsi, un conducteur WPP relie l'entrée du circuit TSCT à la borne P2.

Une opération d'écriture de données dans la mémoire MEM2 comprend d'abord une étape d'envoi d'une commande d'écriture au circuit intégré IC2 puis une étape d'application de la tension HV à la borne P2. Le circuit CCT2 doit attendre que la tension HV apparaisse sur la borne P2 avant d'exécuter la commande. Diverses méthodes peuvent être prévues pour synchroniser l'exécution de la commande d'écriture avec l'apparition de la tension HV.

Selon une première méthode, la tension HV est appliquée à la borne P2 après un temps déterminé suivant l'application de la commande. Le circuit CCT2 comporte une minuterie interne qui lui indique que ce temps déterminé est écoulé et qu'il peut activer le circuit TSCT. La minuterie est par exemple un compteur qui compte les cycles du signal d'horloge S2 reçu sur la borne P3. Une telle méthode de synchronisation par comptage présente certaines contraintes et implique notamment une programmation correspondante de l'organe externe qui applique la tension HV. En effet, afin de fournir la tension HV au bon instant, celui-ci doit lui-mêne compter le nombre de cycles d'horloge qu'il émet.

Une seconde méthode prévoit une détection de la tension HV par le circuit intégré et est mise en oeuvre dans le mode de réalisation représenté sur la figure 3. Le circuit intégré IC2 comprend un détecteur de la tension HV, ici un comparateur CMP. Le comparateur CMP a une première entrée recevant la tension Vdd et une seconde entrée reliée à la borne P2 par l'intermédiaire du point milieu d'un pont diviseur de tension. Le pont diviseur de tension comprend par exemple deux résistances Ra, Rb en série connectées entre la borne P2 et la masse. La seconde entrée du comparateur reçoit ainsi une fraction K*V(S1) de la tension V(S1) du signal S1 présente sur la borne P2, K étant inférieur à 1 et par exemple égal à 0,6. La sortie du comparateur CMP fournit au circuit CCT2 un signal de détection DET qui est par exemple à "1" (Vdd) quand la tension HV est présente sur la borne P2, et égal à 0 quand la tension Vdd est présente sur la borne P2. Plus particulièrement, quand la tension V(S1) varie entre 0 et Vdd, la seconde entrée du comparateur CMP reçoit une tension qui varie entre 0 et 0,6*Vdd tandis que la première entrée du comparateur reçoit la tension Vdd. Dans ce cas le signal de détection DET est égal à 0. Quand la tension du signal S1, devient égale à HV, la seconde entrée du comparateur CMP reçoit une tension égale à 0,6*HV, supérieure à la tension Vdd, et le signal DET passe à 1 (Vdd).

Les figures 4A, 4B représentent la forme des signaux S1, S2 lors de la réception de la commande d'écriture et lors de son exécution. Comme indiqué plus haut, on suppose que la commande est reçue via un bus I2C, les signaux S1, S2 formant respectivement un signal de données (SDA) et un signal d'horloge (SCL) au sens du protocole I2C. On distingue une phase E1 de réception de la commande d'écriture, une phase E2 d'effacement d'une zone cible et une phase E3 de programmation de cellules mémoire de la zone cible effacée.

Phase E1 :
Le signal S1 comprend des bits de protocole de communication "Start". "Ack" ("accusé de réception") et "Stop", et des bits formant la commande d'écriture proprement dite. Celle-ci comprend un code opération, une partie de l'adresse de la zone cible à écrire, par exemple une adresse de colonne, les données à écrire, puis le reste de l'adresse de la zone cible, par exemple une adresse de ligne. Les données, l'adresse de colonne et l'adresse de ligne sont appliquées à la mémoire MEM2 par le circuit CCT2, par exemple dans des verrous de programmation, dans un décodeur de colonne et dans un décodeur de ligne de la mémoire, décrits plus loin. Lorsque la phase E1 est terminée et que la commande d'écriture complète a été reçue, le signal S1 n'oscille plus et reste par exemple égal à 1 (Vdd) tandis que le signal d'horloge S2 continue d'être appliqué au circuit intégré pendant les phases suivantes E2, E3.

Phase E2 ;
- le signal S1 est porté à la haute tension HV ;
- le signal de détection DET passe à 1, informant le circuit CCT2 de la présence de la tension HV ;
- le circuit CCT2 applique la commande d'activation ACT au circuit TSCT :
- le circuit TSCT fournit la tension Vpp sous forme de rampe suivi d'un plateau de tension d'amplitude contrôlée, puis remet la tension Vpp à zéro après un laps de temps déterminé ;
- le signal S1 est ramené à la tension Vdd ;
- le signal de détection DET passe à 0, informant le circuit CCT2 de la fin de la phase E2.

Phase E3 :
- le signal S1 est porté à la haute tension HV ;
- le signal de détection DET passe à 1 ;
- le circuit CCT2, applique une commande de programmation à la mémoire MEM2 et applique la commande d'activation ACT au circuit TSCT ;
- le circuit TSCT fournit la tension Vpp, puis la remet à zéro après un laps de temps déterminé ;
- le signal S1 est ramené à la tension Vdd ;
- le signal de détection DET passe à 0.

Il va de soi que la durée d'application de la tension HV au cours des phases E2, E3 doit être au moins égale et de préférence supérieure au temps nécessaire à l'effacement et la programmation de la zone cible. Par ailleurs, le fait que la tension sur la borne P2 repasse à Vdd entre les deux phases E2, E3 est optionnel et permet seulement de resynchroniser le circuit intégré relativement à la tension HV avant le déclenchement de la phase de programmation E3. Alternativement, un seul créneau de tension HV pourrait être appliqué au circuit intégré pendant les phases E2, E3.

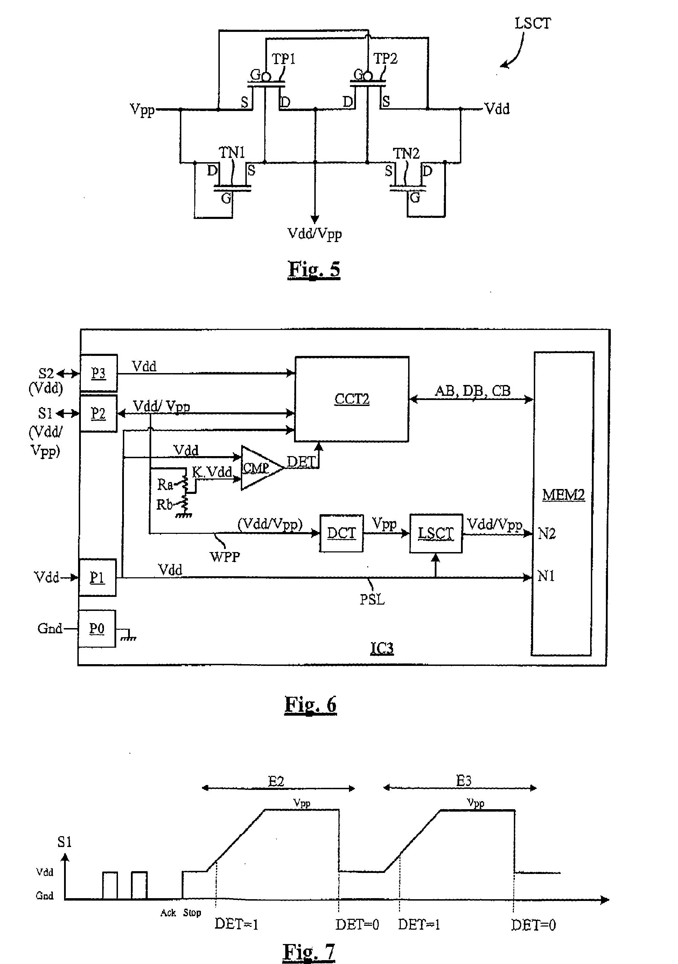

Un exemple simple de réalisation du circuit élévateur de tension LSCT est représenté sur la figure 5. Celui-ci comprend deux transistors TP1, TP2 de type PMOS en série et deux transistors TN1, TN2 de type NMOS en série. Chaque groupe de transistors en série est agencé en parallèle entre l'entrée du circuit LSCT recevant la tension Vdd et l'entrée recevant la tension Vpp. Les transistors TN1, TN2 sont montés en diodes. Le point milieu du groupe de transistors TP1, TP2 est connecté au point milieu du groupe de transistors TN1, TN2 et forme la sortie du circuit élévateur de tension. La source du transistor TP1 est reliée à la première entrée du circuit LSCT tandis que sa grille est reliée à la seconde entrée du circuit LSCT. La source du transistor TP2 est reliée à la seconde entrée du circuit LSCT tandis que sa grille est reliée à la première entrée du circuit LSCT. Le circuit LSCT fonctionne comme un multiplexeur de tension à diodes sans perte de tension grâce aux transistors TP1, TP2, et fournit sur sa sortie la tension qui est la plus élevée, c'est-à-dire la tension Vpp ou la tension Vdd quand la tension Vpp est absente, la sortie du circuit TSCT étant supposée ici maintenir la tension Vpp à 0 en l'absence de la tension HV, pour que le transistor TP2 soit passant.

### Deuxième mode de réalisation

Un deuxième mode de réalisation d'un circuit intégré à mémoire IC3 selon l'invention est représenté sur la figure 6. Le circuit intégré diffère du circuit IC2 en ce qu'il ne comporte pas le circuit minuteur-séquenceur TSCT. L'entrée haute tension du circuit élévateur de tension LSCT est donc reliée directement à la borne de connexion P2 du circuit IC3, ou est reliée à la borne P2 par l'intermédiaire d'un circuit de découplage DCT décrit plus loin. Les entrées du comparateur CMP reçoivent comme précédemment la tension Vdd et une faction K de la tension V(S1) du signal S1, fournie par le pont diviseur Ra, Rb.

Comme illustré sur la figure 7, la haute tension appliquée à la borne P2 pendant les phases E2, E3 est de préférence la tension Vpp mise en forme, ayant par exemple la forme d'une rampe suivie d'un plateau de tension régulé, plutôt qu'une haute tension HV à l'état brut sous forme de créneau de tension comme celle appliquée au circuit IC2 (Fig. 4B). Toutefois, l'application de la haute tension HV sans rampe et sans régulation pourrait être envisagée dans certaines applications, en fonction de la robustesse des cellules mémoire et de la durée de vie souhaitée pour la mémoire MEM2. Par ailleurs, comme la durée de la tension Vpp n'est plus contrôlée par le circuit intégré, la durée d'applicaticn de la tension Vpp doit également être contrôlée par l'organe externe qui fournit cette pension. Comme précédemment, la synchronisation des phases E2, E3 avec la tension Vpp est faite au moyen du comparateur CMP utilisé en tant que détecter de la tension Vpp, mais pourrait également être faite par comptage de cycles d'horloge.

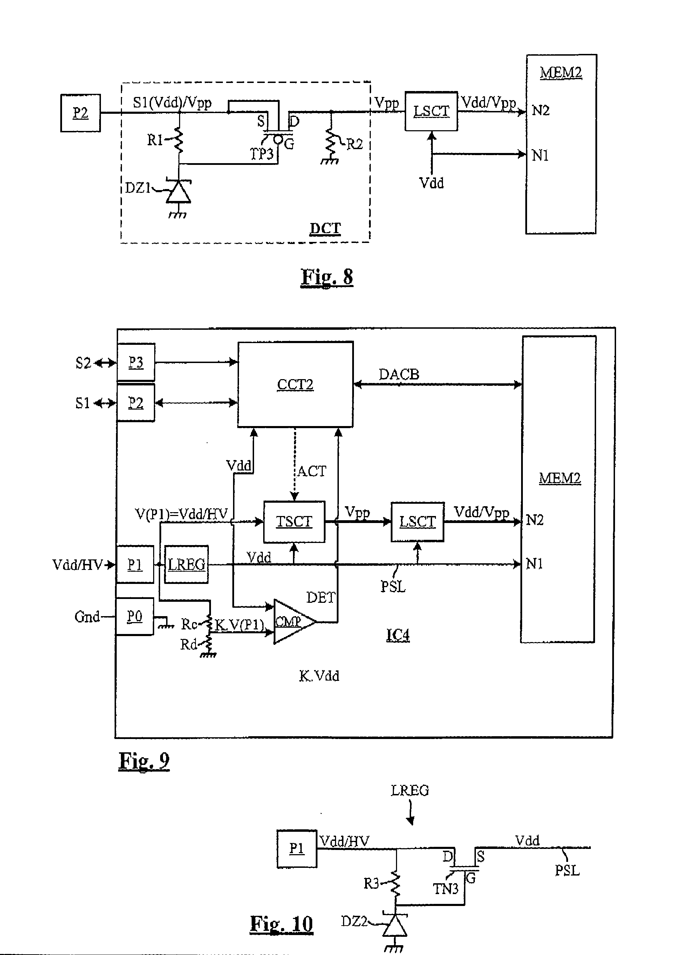

La figure 8 illustre un mode de réalisation simple et de faible encombrement du circuit de découplage DCT. Le circuit DCT isole l'entrée haute tension du circuit élévateur de tension LSCT, et par conséquent le noeud d'alimentation N2 de la mémoire, du bruit causé par les fluctuations du signal S1 en dehors des phases d'effacement E2 et de programmation E3. Il comprend par exemple une diode Zener DZ1, une résistance R1, un transistor PMOS TP3 et une résistance R2. La diode DZ1 et la résistance R1 sont agencées en série entre la borne P2 et la masse. Le transistor TP3 a sa source connectée à la borne P2, son drain connecté à l'entrée haute tension du circuit LSCT et sa grille connectée entre la résistance R1 et la diode DZ1. La résistance R2 est agencée entre le drain du transistor TP3 et la masse.

Tant que la tension sur la borne P2 est inférieure à la tension Zener, par exemple 5 V, la diode DZ1 est bloquée, la grille du transistor TP3 est maintenue au même potentiel que sa source S par la résistance R1, tandis que le drain D du transistor est tiré à la masse par la résistance R2. Le transistor TP3 est bloqué. Lorsque la tension Vpp apparaît sur la borne P2 et devient supérieure à la tension Zener, la diode D21 devient passante, la résistance R1 est traversée par un courant. Lorsque la tension Vpp devient égale à la somme de la tension Zener et de la tension de seuil du transistor TP3, la tension aux bornes de la résistance R1 est alors égale à la tension de seuil du transistor TP3 et celui-ci devient passant. La tension Vpp est appliquée au noeud d'alimentation N2 de la mémoire par l'intermédiaire du circuit LSCT.

### Troisième mode de réalisation

La figure 9 représente un circuit intégré à mémoire IC4 qui se distingue du circuit IC2 précédemment décrit en ce que la borne d'alimentation P1 est ici utilisée pour fournir la tension HV au circuit intégré. Ainsi, la tension V(P1) appliquée à la borne P1 est égale à Vdd en dehors des périodes d'effacement ou de programmation et est égale à la tension HV pendant ces périodes.

L'entrée du circuit minuteur-séquenceur TSCT est connectée à la borne P1 au lieu d'être connectée à la borne P2. Le circuit intégré IC4 comprend en outre un circuit régulateur limiteur de tension LREG agencé entre la borne P1 et la ligne d'alimentation interne PSL qui véhicule la tension Vdd. Comme précédemment, le noeud d'alimentation N2 de la mémoire est connecté à la sortie du circuit minuteur-séquenceur TSCT par l'intermédiaire du circuit élévateur de tension LSCT et le noeud d'alimentation N1 de la mémoire est connecté à la ligne PSL.

Le comparateur CMP fournissant le signal de détection DET a ici sa première entrée connectée à la sortie du circuit régulateur limiteur LREG. Sa seconde entrée est reliée à la borne P1 par l'intermédiaire du point milieu d'un pont diviseur de tension comprenant par exemple deux résistances en série Rc, Rd agencées entre la borne P1 et la masse. La seconde entrée du comparateur CMP reçoit ainsi une tension K*V(P1) qui peut être égale à K*Vdd ou à K*HV, K étant inférieur à 1 et par exemple égal à 0,6. Lorsque V(P1)=Vdd, le régulateur limiteur LREG fournit à la ligne PSL une tension égale à ou proche de la tension Vdd (à la perte de tension dans le régulateur limiteur près). Dans ce cas, la tension K*Vdd est inférieure à la tension Vdd et le signal DET est égal à 0.

Lorsqu'une commande d'écriture de données a été appliquée au circuit intégré IC4 par l'intermédiaire de la borne P2, la tension V(P1) est portée à la haute tension HV pour permettre au circuit de contrôle CCT2 de conduire les phases d'effacement E2 et de programmation E3. Lorsque V(P1) passe de Vdd à HV, le régulateur limiteur LREG continue de fournir une tension égale à Vdd ou proche de celle-ci. La tension K*HV devient supérieure à la tension Vdd et le signal DET passe à 1 (Vdd). Le circuit de contrôle CCT2 déclenche le circuit minuteur-séquenceur TSCT de la manière précédemment décrite.

Dans une variante de réalisation inspirée du deuxième mode de réalisation décrit plus haut, le circuit intégré IC4 ne comporte pas le circuit TSCT et reçoit la tension Vpp sur la borne P1, dont la forme et durée sont contrôlées par l'organe externe qui fournit cette tension.

La figure 10 représente un mode de réalisation simple et de faible encombrement du circuit régulateur limiteur de tension LREG. Celui-ci comprend une diode Zener DZ2, une résistance R3 et un transistor TN3 de type NMOS. La diode DZ2 et la résistance R3 sont agencées en série entre l'entrée du régulateur (borne P1) et la masse. Le drain D du transistor TN3 est connecté à l'entrée du régulateur, sa source S forme la sortie du régulateur et est connectée à la ligne d'alimentation interne PSL, sa grille G est connectée entre la résistance R3 et la diode DZ2.

Tant que la tension sur la borne P1 est égale à Vdd et est inférieure à une tension Zener VZ, par exemple 5 V, la grille G du transistor TN3 est maintenue au même potentiel que son drain D par la résistance R3. Le transistor TN3 fonctionne en diode et transfère la tension Vdd sur sa source, avec une perte de tension égale à sa tension de seuil Vt. Quand la tension appliquée à la borne P1 croit et devient supérieure à la tension Vdd, la diode DZ2 devient conductrice. La tension de grille G du transistor est égale à la tension Zener et la tension fournie par la source du transistor est égale à VZ-Vt. En conséquence, le régulateur fournit au circuit intégré une tension d'alimentation égale à Vdd-Vt lorsque la tension Vdd est appliquée à la borne P1 ou égale à VZ-Vt lorsque la tension Vpp est appliquée à la borne P1. Si la tension Vdd est proche de la tension VZ, la tension d'alimentation Vdd-Vt sur la ligne PSL reste sensiblement constante. Il va de soi que l'homme de l'art pourra prévoir diverses autres structures de régulateur, notamment une structure sans perte de tension.

### Autres modes de réalisation

Un circuit intégré à mémoire selon l'invention est susceptible de divers autres modes de réalisation.

Dans un mode de réalisation, la haute tension HV ou Vpp est appliquée au circuit intégré sous forme pulsée par l'intermédiaire de la borne d'horloge P2, en portant la valeur crête du signal d'horloge à la tension HV ou Vpp. Dans ce cas, le circuit intégré comprend un circuit limiteur de tension ou un comparateur pour fournir un signal d'horloge ayant une tension crête qui soit égale ou proche de la tension Vdd lorsque la tension Vpp est appliquée à la borne P2. Il comprend d'autre part un circuit de redressement (par exemple une diode) suivi d'un circuit de filtrage (par exemple un condensateur) pour transformer le signal d'horloge en tension continue HV ou Vpp. Alternativement, la haute tension HV ou Vpp peut être superposée au signal d'horloge. Dans ce cas, le circuit intégré peut comprendre un circuit passe-haut ou un comparateur pour extraire le signal d'horloge du signal reçu par la borne P2, et un circuit de redressement et de filtrage pour extraire la tension HV ou Vpp de ce signal.

Ce mode de réalisation est applicable également à un circuit intégré ayant une borne de connexion recevant un signal de données incluant un signal d'horloge, notamment un circuit intégré n'ayant que deux bornes de connexion, une borne de masse et une borne de signal de données et d'horloge. Un tel circuit intégré reçoit à la fois la tension Vdd et la tension HV ou Vpp par l'intermédiaire de la borne de réception du signal de données et d'horloge. Un circuit de filtrage et de lissage du signal de données et d'horloge extrait une première tension qui peut être la tension Vdd en dehors des phases d'effacement ou de programmation E2, E3 ou la tension Vpp pendant les phases E2, E3. Pendant les phases E2, E3, un circuit limiteur connecté à la sortie du circuit de filtrage et de lissage reçoit la tension HV ou Vpp et fournit la tension Vdd au circuit intégré.

La haute tension HV ou Vpp peut également être appliquée à la borne P2 sans le signal d'horloge S2 pendant les phases E2, E3, si le circuit intégré comporte un générateur de signal d'horloge interne ou simplement une base de temps interne déterminant le temps d'effacement et le temps de programmation.

Dans un mode de réalisation, le circuit intégré est dépourvu de moyen de mise en forme de la haute tension Vpp, tel le générateur de rampe ou le régulateur de la tension de plateau, mais comporte une minuterie lui permettant de contrôler la durée d'application de la tension Vpp à la mémoire MEM2. Dans ce cas, l'organe externe qui fournit la tension Vpp assure la mise en forme et la régulation de cette tension.

Par ailleurs, l'invention est également applicable à des circuits intégrés comprenant une mémoire programmable électriquement mais non effaçable, ou à des circuits intégrés comprenant une mémoire effaçable électriquement mais non programmable.

Un circuit intégré selon l'invention peut également comprendre un plus grand nombre de bornes de communication. Par exemple, le circuit intégré peut être conçu pour être connecté à un bus SPI ("Serial Peripheral Interface Bus") comprenant quatre bornes de connexion : "SCLK" (Horloge, signal généré par un circuit maître externe), "MOISI" ("Master Output, Slave Input", signaux générés par le circuit maître), "MISO" ("Master Input, Slave Output", signaux générés par le circuit intégré) et "SS" ("Slave Select", signaux générés par le circuit maître). Dans ce cas, la tension Vpp peut être fournie au circuit intégré par l'intermédiaire de sa borne d'émission de données ou par l'intermédiaire de sa borne de réception de données.

Par ailleurs, bien que l'on ait considéré dans ce qui précède l'exemple d'un circuit intégré à mémoire recevant des commandes d'écriture et exécutant de telles commandes en conduisant un cycle d'effacement suivi d'un cycle de programmation, la présente invention peut s'appliquer à un circuit intégré configuré pour recevoir des commandes d'effacement et de programmation distinctes. De telles commandes peuvent être des commandes d'effacement de données, de pages ou de secteurs de la mémoire, voire une commande d'effacement de l'ensemble de la mémoire, des commandes de programmation de données dans des blocs, dans des pages ou dans des secteurs de la mémoire. Il peut s'agir également de commandes d'écriture qui ne sont pas accompagnées de données. Par exemple, une commande spécifique peut être prévue pour demander au circuit intégré de coder une suite de 0 et de 1 en alternance dans la mémoire pendant une phase de test. Une telle commande ne nécessite pas la fourniture des données 0 et 1 au circuit intégré.

De manière générale, et dans un souci de simplification du langage, le terme "commande d'écriture" désigne donc dans la présente demande tout type de commande dont l'exécution nécessite de fournir à la mémoire une tension supérieure à la tension d'alimentation du circuit intégré.

### Réalisation d'un dispositif pour fournir la haute tension externe HV ou Vpp à un ou plusieurs circuits intégrés

On a décrit dans ce qui précède des modes de réalisation d'un circuit intégré recevant une haute tension externe HV ou Vpp par l'intermédiaire d'une borne de connexion non dédiée, pendant des phases d'écriture de données dans sa mémoire. Un tel circuit intégré peut être destiné à être utilisé comme une étiquette électronique contenant des données préenregistrées lors de sa mise en service. Le processus d'écriture de données avant la mise en service du circuit intégré est appelé "personnalisation". Ce processus est généralement mis en oeuvre au moyen d'un circuit maître qui est relié à une pluralité de circuits intégrés à mémoire par l'intermédiaire d'un bus de données, par exemple un bus I2C, et qui personnalise les circuits intégrés les uns après les autres.

Afin de fournir la haute tension HV ou Vpp aux circuits intégrés pendant le processus de personnalisation, il peut être prévu de modifier la structure du circuit maitre pour qu'il fournisse lui-même cette tension. Toutefois, il peut aussi être souhaité de ne pas modifier la structure du circuit maître. Notamment, il peut être souhaité de personnaliser des circuits intégrés selon l'invention au moyen d'un système de personnalisation existant, équipé d'un circuit maître qui n'est pas conçu pour fournir une telle tension aux circuits intégrés.

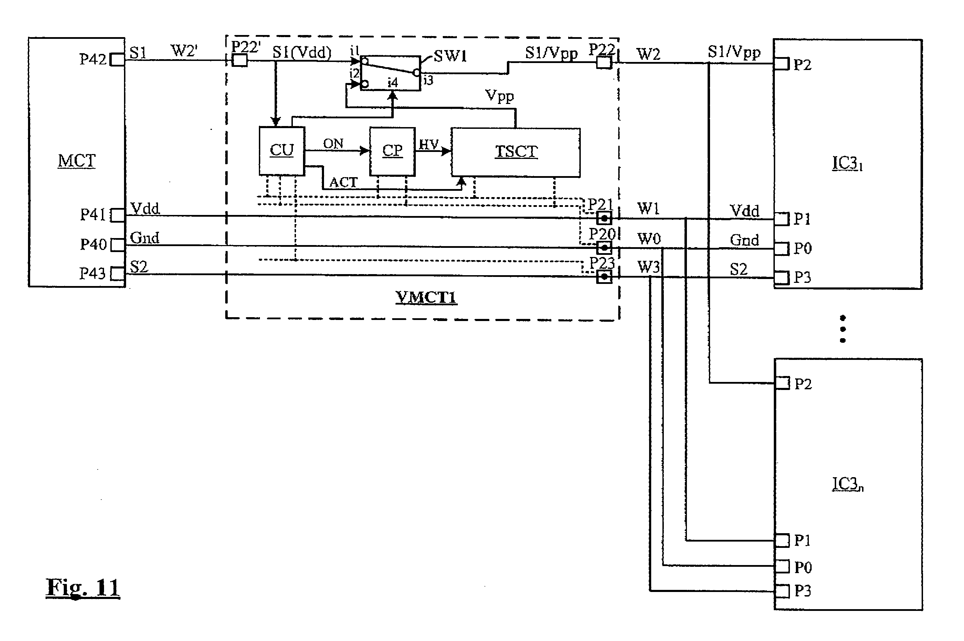

Un mode de réalisation de l'invention concerne un dispositif de gestion de tension VMCT1 dont la structure est représentée sur la figure 11. Le dispositif VMCT1 est dédié à la fourniture de la tension HV ou Vpp. Il peut être réalisé sous la forme de circuit intégré sur microplaquette de semi-conducteur ou sous forme de circuit à composants discrets sur circuit imprimé. Le dispositif VMCT1 est connecté à un bus de données reliant un circuit maître MCT à des circuits intégrés à mémoire IC3₁, ... IC3n selon l'invention.

Le bus de données comprend des fils W0, W1, W2, W2, W3 (le terme "fil" couvre tout type de conducteur utilisable pour relier le circuit maître aux circuits intégrés, y compris une carte à pointes si la personnalisation est faite sur wafer de silicium, avant découpe des circuits intégrés). Le dispositif VMCT1 comporte des bornes de connexion P20, P21, P22, P22', P23. Le circuit maître comprend des bornes de connexion P40, P41, P42, P43. Chaque circuit intégré comprend les bornes P0 (masse), P1 (Vdd), P2 (signal S1) et P3 (signal S2) précédemment décrites. Le fil W0 relie la borne P0 de chaque circuit intégré IC3 à la borne P40. Le fil W1 relie la borne P1 (Vdd) de chaque circuit intégré IC3 à la borne P41. Le fil W3 relie la borne P3 de chaque circuit intégré IC3 à la borne P43. La borne P20 du dispositif VMCT1 est connectée au fil WO, la borne P21 est connectée au fil W1 et la borne P23 est connectée au fil W3. Enfin, la borne P2 de chaque circuit intégré IC3 est connectée à la borne P22 du dispositif VMCT1. La borne P22' du dispositif VMCT1 est connectée à la borne P42 du circuit maître MCT. Le dispositif VMCT1 s'interpose ainsi entre les circuits intégrés et le circuit maître sur le fil de données W2, W2' véhiculant le signal S1.

Le dispositif VMCT1 est conçu pour fournir une tension Vpp de forme, d'amplitude et de durée contrôlées. Il comprend ici une pompe de charge CP pour fournir la tension HV et un circuit minuteur-séquenceur TSCT du type déjà décrit, pour fournir la tension Vpp à partir de la tension HV.

Le dispositif VMCT1 comporte également une unité centrale espion CU, de type séquenceur à logique câblée ou de type microprocesseur, et un interrupteur SW1. L'interrupteur SW1 comporte une borne i1 connectée à la borne P22', une borne i2 connectée à la sortie du circuit TSCT et une borne i3 connectée à la borne P22. L'interrupteur comporte également une entrée de contrôle i4 pilotée par l'unité centrale, au moyen de laquelle l'unité centrale peut placer l'interrupteur dans un état transparent où la borne i1 est reliée à la borne i3, ou dans un état non transparent où la borne i2 est reliée à la borne i3. Dans l'état transparent, la borne P22 est reliée à la borne P22' et le signal S1 peut circuler entre le circuit maître MCT et les circuits intégrés IC3. Dans l'état non transparent, la borne P22 est reliée à la sortie du circuit TSCT et la tension Vpp est appliquée à la borne P2 de chaque circuit intégré IC3.

L'unité centrale espion CU est configurée pour initialement placer l'interrupteur SW1 dans l'état transparent, surveiller les données véhiculées par le signal S1 et circulant sur le fil W2, W2', et détecter l'émission d'une commande d'écriture par le circuit maître MCT, sans nécessairement déterminer à quel circuit intégré IC3 elle est destinée. A cet effet, l'unité centrale espion CU surveille et analyse les signaux de données circulant sur le fil W2, W2', identifie les formats de commandes suivant le protocole dans lequel ces données sont formatées, et identifie les commandes d'écriture. Comme indiqué plus haut, le terme "commande d'écriture" inclut tout type de commande dont l'exécution nécessite de fournir la tension HV ou Vpp aux circuits intégrés.

Lorsqu'une commande d'écriture complète a été détectée, l'unité centrale applique un signal d'activation "ON" à la pompe de charge CP, applique la commande d'activation ACT au circuit TSCT puis place l'interrupteur SW1 dans l'état non transparent. Le circuit TSCT fournit alors la tension Vpp aux circuits intégrés IC3₁,...IC3n. Le circuit intégré IC3 visé par la commande utilise cette tension pour exécuter la commande.

Dans une variante de réalisation du dispositif VMCT1, non représentée, la tension Vpp est appliquée à la borne d'alimentation P1 des circuits intégrés par l'intermédiaire du fil W1. Les circuits intégrés sont alors réalisés conformément au troisième mode de réalisation représenté sur la figure 9. Dans ce cas, le dispositif VMCT1 comprend une borne supplémentaire P21' connectée à la borne P41 du circuit maître par l'intermédiaire d'un fil W1' (non représenté). La borne P21 est connectée à la borne P1 des circuits intégrés par l'intermédiaire du fil N1, et les bornes i3, i1 de l'interrupteur SW1 sont connectées respectivement aux bornes P21 et P21'. La borne P22' et le fil W2' sont supprimés et la borne P42 du circuit MCT est reliée à la borne P2 des circuits intégrés IC3 au moyen du fil W2. La borne P22 est connectée au fil W2 pour permettre au dispositif VMCT1 de surveiller les commandes circulant sur le bus.

Dans encore une autre variante de réalisation du dispositif de gestion de tension, non représentée, la tension Vpp est appliquée à la borne P3 (signal d'horloge S2) des circuits intégrés par l'intermédiaire du fil W3. Ces derniers sont dans ce cas réalisés conformément au mode de réalisation décrit plus haut, pour extraire du signal d'horloge survolté qui leur est fourni un signal d'horloge de tension proche de Vdd, et d'autre part la tension Vpp.

Dans encore une autre variante de réalisation, non représentée, le dispositif VMCT1 est réalisé à partir de composants discrets sur support d'interconnexion et reçoit de l'extérieur une tension de 15 à 20V formant la tension HV, générée par exemple au moyen de la tension alternative du secteur. La génération de la rampe de tension Vpp est faite au moyen d'amplificateurs opérationnels ou de transistors discrets. La tension d'alimentation "Vdd" du dispositif VMCT1 peut par ailleurs être indépendante de celle du circuit MCT. Dans ce cas, la connexion à la borne P1 des circuits intégrés pour recevoir la tension Vdd n'est pas nécessaire, à l'exception d'un mode de réalisation où les circuits intégrés reçoivent la tension HV par l'intermédiaire de la borne P1.

Par ailleurs, l'interrupteur SW1 peut être remplacé par tout autre moyen d'injection de la tension Vpp sur le bus de données, tel un amplificateur suiveur configuré en élévateur de tension et connecté entre les bornes P22' et P22. L'amplificateur suiveur est alimenté par la tension Vdd quand le dispositif VMCT1 est dans l'état transparent et est alimenté par la tension Vpp pendant les phases E2, E3. Des portes inverseuses alimentées par la tension Vdd quand le dispositif VMCT1 est dans l'état transparent et alimentées par la tension Vpp pendant les phases E2, E3 pourraient également être utilisées. Ce mode de réalisation est envisageable si le signal S1 est maintenu à 1 (Vdd) par le circuit maître MCT pendant les phases E2, E3.

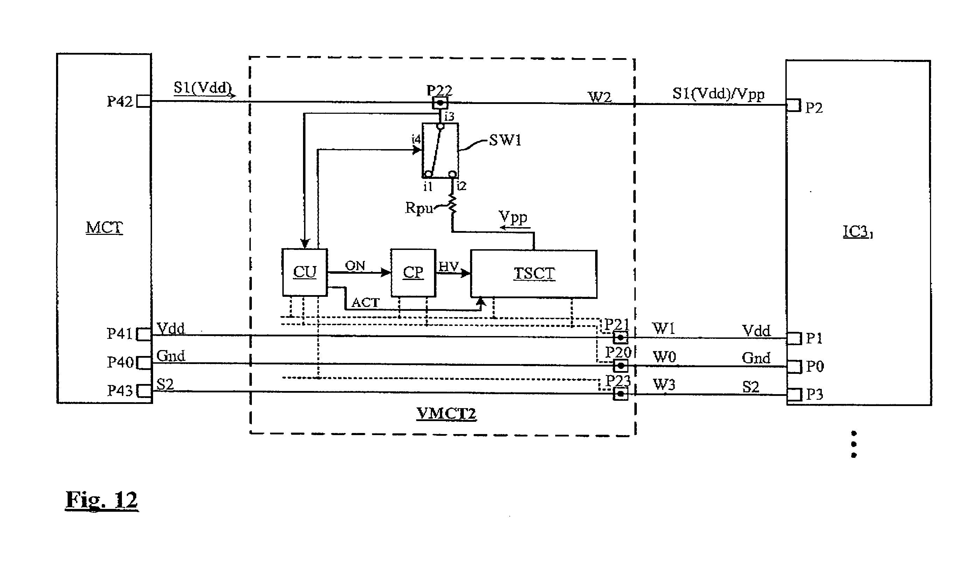

Une autre variante VMCT2 du dispositif de gestion de tension selon l'invention est représentée sur la figure 12. Le dispositif VMCT2 se distingue du dispositif VMCT1 en ce qu'il ne comporte pas la borne P22'. La borne P22 est reliée à la fois à la borne P42 du circuit maître MCT et aux bornes P2 des circuits intégrés IC3 par l'intermédiaire du fil W2. La borne P22 est également reliée à la borne i4 de l'interrupteur SW1. L'entrée i1 de l'interrupteur n'est connectée à rien et l'entrée i2 est reliée à la sortie du circuit TSCT par l'intermédiaire d'une résistance Rpu de polarisation à l'état haut (résistance de "pull-up"). Ainsi, lorsque l'unité centrale CUI place l'interrupteur SW1 dans l'état non transparent (borne i2 connectée à la borne i3), la tension Vpp est appliquée sur le fil de données W2. Ce mode de réalisation est par exemple applicable à un circuit maître MCT qui met le signal S1 à haute impédance pendant les phases E2, E3.

L'homme de l'art notera que le surcoût qu'implique la prévision du dispositif VMCT1 ou VMCT2 est compensé par la réduction du coût de chacun des circuits intégrés à mémoire à qui il fournit la tension HV ou Vpp, puisqu'un seul dispositif de gestion de tension permet de réduire le coût de milliers de circuits intégrés qu'il permet de personnaliser. Pour fixer les idées, un circuit intégré ayant 128 bits de mémoire, de type étiquette électronique, équipé d'un circuit d'interface I2C, réalisé en technologie 0,5 micromètres, nécessite à l'heure actuelle une microplaquette de semi-conducteur d'une surface de l'ordre de 0,6 mm². Un circuit intégré à mémoire selon l'invention, ayant une mémoire similaire mais dépourvu de moyen de génération de la haute tension HV ou Vpp, réalisé également en technologie 0,5 micromètres, peut être intégré sur une microplaquette de semi-conducteur d'une surface de l'ordre de 0,35 mm².

L'homme de l'art notera également que le dispositif VMCT1 ou VMCT2 peut être utilisé avec des circuits intégrés classiques comprenant une borne de contact spécifiquement dédiée à la réception de la tension HV ou Vpp. Ainsi, la prévision du dispositif VMCT1 ou VMCT2 forme un aspect de l'invention qui est indépendant des caractéristiques des circuits intégrés auxquels la tension HV ou Vpp est fournie, en ce qui concerne la borne recevant cette tension.

L'homme de l'art notera enfin que le système représenté sur la figure 11 ou 12, comprenant les circuits intégrés IC3₁,...IC3n, le circuit maître MCT et le dispositif VMCT1, peut être autre chose qu'un système de personnalisation de circuits intégrés avant leur mise en service. Les circuits intégrés IC3 peuvent par exemple être des étiquettes électroniques embarquées dans des cartouches d'encre et le circuit maître MCT peut être un processeur d'imprimante prévu pour gérer de telles cartouches d'encre.

### Exemple de réalisation de la mémoire MEM2

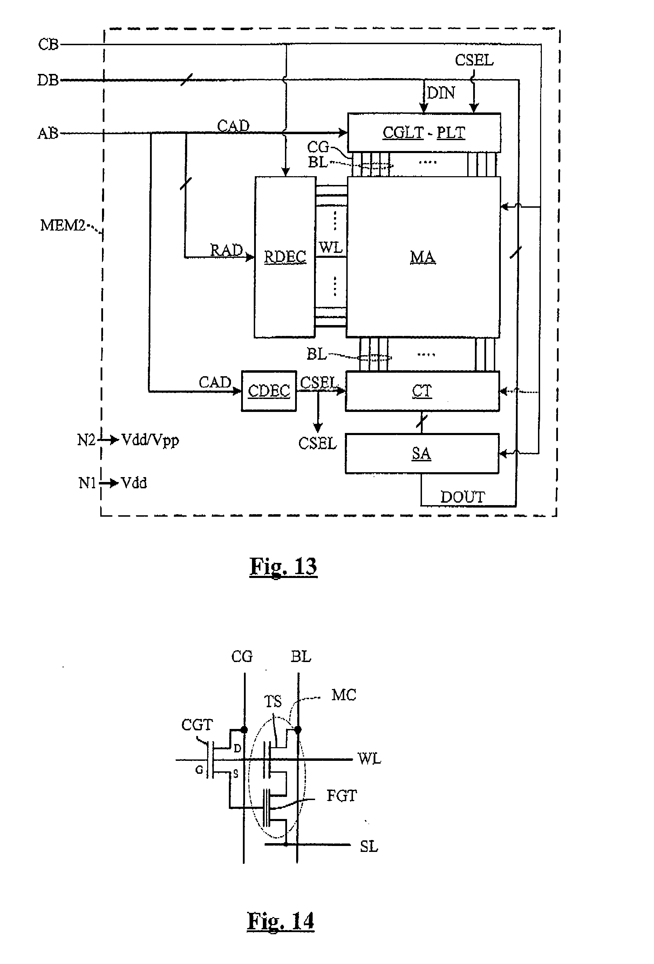

La figure 13 représente un mode de réalisation de la mémoire MEM2. La mémoire comprend un plan mémoire MA, des lignes de mot WL, des lignes de bit BL, un décodeur de ligne RDEC, un décodeur de colonne CDEC, des verrous de contrôle de grille CGLT ("Control Gate Latches"), des verrous de programmation PLT ("Program Latches"), un groupe CT de transistors de sélection de colonne et un groupe d'amplificateur de lecture SA ("Sense Amplifier").

La figure 14 représente un mode de réalisation d'une cellule mémoire MC du plan mémoire MA. La cellule mémoire MC comprend un transistor à grille flottante FGT et un transistor de sélection TS de type MOS. La grille du transistor de sélection TS est pilotée par le décodeur de ligne RDEC par l'intermédiaire d'une ligne de mot WL, le drain du transistor est relié à une ligne de bit BL et sa source est reliée au drain du transistor à grille flottante FGT. La source du transistor FGT est reliée à une ligne de source SL et sa borne de contrôle de grille est reliée à un verrou de contrôle de grille CGLT par l'intermédiaire d'un transistor de contrôle de grille CGT et d'une ligne de contrôle de grille CG, la grille du transistor CGT étant connectée à la ligne de mot WL.

Le plan mémoire MA comprend des groupes de cellules mémoires MC formant ensemble des mots effaçables et programmables individuellement (non représenté), chaque cellule mémoire recevant un bit. Chaque groupe de cellule mémoire formant un mot est contrôlé en effacement par un transistor de contrôle de grille CGT et un verrou CGLT. Chaque ligne de bit BL est connectée à la sortie d'un verrou de programmation PLT. Les lignes de bits BL sont également reliées aux amplificateurs de lecture SA par l'intermédiaire du groupe CT de transistors de sélection de colonne. Les décodeurs RDEC, CDEC sont reliés au circuit de contrôle CCT2 par l'intermédiaire d'un bus d'adresse AB et reçoivent respectivement une adresse de ligne RAD et une adresse de colonne CAD formant l'adresse d'un mot dans le plan mémoire. Le décodeur CDEC fournit des signaux de sélection de colonne CSEL au groupe CT de transistors de sélection de colonne ainsi qu'aux verrous de contrôle de grille CGLT et aux verrous de programmation PLT. Les verrous de programmation PLT et les amplificateurs de lecture SA sont reliés au circuit de contrôle CCT2 par l'intermédiaire d'un bus de données DB. Des données à écrire DIN dans le plan mémoire sont enregistrées dans des verrous de programmation sélectionnés par le décodeur CDEC au moyen des signaux CSEL. En lecture, des lignes de bit BL sont reliées aux amplificateurs de lecture SA par l'intermédiaire de transistors du groupe CT sélectionnés par le décodeur CDEC au moyen des signaux CSEL. Des données POUT sont lues dans des cellules mémoire par les amplificateurs de lecture SA et sont fournies sur le bus DB. Enfin, un bus de contrôle CB relie également le circuit CCT2 à ces différents éléments, pour commander des opérations d'effacement, de programmation, et de lecture du plan mémoire.

Dans cet exemple de réalisation de la mémoire MEM2, certains éléments comme les amplificateurs de lecture SA ne nécessitent que la tension Vdd pour fonctionner et sont donc reliés au noeud d'alimentation N1. D'autres éléments nécessitent la tension Vdd et la tension Vpp et sont reliés au noeud d'alimentation N2. Par exemple les décodeurs de ligne RDEC et de colonne CDEC nécessitent la tension Vdd pour la sélection de cellules mémoire en mode lecture du plan mémoire puis la tension Vpp pour l'effacement ou la programmation de cellules mémoire. Les verrous CGLT nécessitent la tension Vdd pour sélectionner la colonne contentant le mot à effacer ou à programmer (zone cible) puis la tension Vpp pour effacer le mot. Les verrous PLT nécessitent la tension Vdd pour recevoir les données à écrire DIN puis la tension Vpp pour programmer ces données dans les cellules mémoire sélectionnées par les décodeurs RDEC, CDEC.

Enfin, il sera noté que les divers organes de la mémoire, à l'exception du plan mémoire, pourraient en pratique être intégrés dans le circuit de contrôle CCT2, la mémoire proprement dite étant essentiellement formée par le plan mémoire MA. Ainsi, le noeud d'alimentation N2 de la mémoire, recevant la tension Vpp, pourrait également être un noeud d'alimentation de circuit de contrôler CCT2.

## Revendications

1. Circuit intégré à mémoire (IC2-IC4) alimenté électriquement par une tension d'alimentation (Vdd) et comprenant une mémoire (MEM2) effaçable et/ou programmable électriquement au moyen d'une seconde tension (HV, Vpp) supérieure à la tension d'alimentation (Vdd),
**caractérisé en ce qu'**il comprend des moyens (WPP, TSCT, CMP, LSCT) pour recevoir la seconde tension (HV, Vpp) par l'intermédiaire d'une borne (P1) de réception de la tension d'alimentation (Vdd) ou par l'intermédiaire d'une borne (P2, P3) de réception ou d'émission d'un signal de données ou d'horloge (S1, S2).

2. Circuit intégré à mémoire selon la revendication 1, comprenant :
- des moyens pour recevoir la seconde tension (HV, Vpp) par l'intermédiaire d'une borne (P1) de réception de la tension d'alimentation (Vdd), et
- un circuit régulateur limiteur de tension (LREG) ayant une entrée reliée à la borne de réception (P1) de tension d'alimentation et fournissant la tension d'alimentation (Vdd) lorsque la seconde tension est présente sur la borne de réception (P1).

3. Circuit intégré à mémoire selon la revendication 1, comprenant :
- des moyens pour recevoir la seconde tension (HV, Vpp) par l'intermédiaire d'une borne (P2) de réception ou d'émission d'un signal de données (S1), et
- un circuit de découplage (DCT) ayant une entrée reliée à la borne (P2) de réception ou d'émission du signal de données et une sortie reliée à un noeud d'alimentation (N2) du circuit intégré destiné à recevoir la seconde tension (HV, Vpp),
le circuit de découplage étant configuré pour empêcher les fluctuations du signal de données (S1) d'atteindre le noeud d'alimentation (N2), et pour transférer la seconde tension (HV, Vpp) au noeud d'alimentation (N2) lorsqu'elle est présente sur la borne (P2) de réception ou d'émission du signal de données.

4. Circuit intégré à mémoire selon la revendication 1, comprenant :
- des moyens pour recevoir la seconde tension (HV, Vpp) par l'intermédiaire d'une borne (P3) de réception d'un signal d'horloge (S2), et
- un circuit de redressement ayant une entrée reliée à la borne (P3) de réception de signal d'horloge et une sortie reliée à un noeud d'alimentation (N2) du circuit intégré, pour fournir la seconde tension (HV, Vpp) au noeud d'alimentation lorsqu'elle est présente sur la borne de réception de signal d'horloge.

5. Circuit intégré à mémoire selon l'une des revendications 1 à 4, comprenant également des moyens pour recevoir la tension d'alimentation (Vdd) par l'intermédiaire d'une borne (P2, P3) de réception d'un signal de données ou d'horloge (S1, S2).

6. Circuit intégré selon l'une des revendications 1 à 5, configuré pour appliquer la seconde tension (HV, Vpp) à la mémoire (MEM2) sans contrôler la durée ni la forme de la seconde tension.

7. Circuit intégré selon l'une des revendications 1 à 6, comprenant un circuit élévateur de tension (LSCT) comprenant une première entrée recevant la tension d'alimentation (Vdd), une seconde entrée recevant la seconde tension (Vpp), et une sortie fournissant la seconde tension (Vpp) à la mémoire (MEM2) lorsque celle-ci est présente sur la seconde entrée, sinon fournissant la tension d'alimentation (Vdd).

8. Circuit intégré selon l'une des revendications 1 à 7, comprenant :
- un circuit de contrôle (CCT2) configuré pour exécuter des commandes d'effacement et/ou de programmation de la mémoire, et
- un circuit (CMP) de détection de la présence de la seconde tension (HV, Vpp), fournissant un signal de détection (DET) au circuit de contrôle pour la synchronisation du circuit de contrôle relativement à l'apparition de la seconde tension.

9. Système électronique comprenant :
- au moins un circuit intégré à mémoire (IC3₁-IC3ₙ) alimenté électriquement par une tension d'alimentation (Vdd) et comprenant une mémoire (MEM2) effaçable et/ou programmable électriquement au moyen d'une seconde tension (HV, Vpp) supérieure à la tension d'alimentation (Vdd),
- un bus de données (W1-W3, W2') connecté au circuit intégré à mémoire,
**caractérisé en ce qu'**il comprend des moyens (MCT, VMCT1, VMCT2) pour appliquer la seconde tension (HV, Vpp) au circuit intégré par l'intermédiaire d'un fil (W1, W2, W3) du bus de données qui est connecté à une borne (P1) de réception de la tension d'alimentation (Vdd) du circuit intégré ou à une borne (P2, P3) de réception ou d'émission d'un signal de données ou d'horloge (S1, S2) du circuit intégré.

10. Système électronique selon la revendication 9, dans lequel les moyens pour appliquer la seconde tension (HV, Vpp) comprennent un dispositif de gestion de tension (VMCT1, VMCT2) connecté audit fil (W1, W2, W3) du bus de données et agencé pour :
- surveiller les communications sur le bus de données et détecter le fait qu'une commande d'écriture a été appliquée au circuit intégré, et
- appliquer la seconde tension (HV, Vpp) sur ledit fil du bus de données lorsque la commande d'écriture a été détectée.

11. Procédé pour écrire des données dans un circuit intégré à mémoire (IC2-IC4) alimenté électriquement par une tension d'alimentation (Vdd) et comprenant une mémoire (MEM2) effaçable et/ou programmable électriquement au moyen d'une seconde tension (HV, Vpp) supérieure à la tension d'alimentation (Vdd),
procédé **caractérisé en ce qu'**il comprend les étapes consistant à :
- appliquer une commande d'écriture au circuit intégré, puis
- fournir la seconde tension (HV, Vpp) au circuit intégré par l'intermédiaire d'une borne (P1) de réception de la tension d'alimentation (Vdd) ou par l'intermédiaire d'une borne (P2, P3) de réception ou d'émission d'un signal de données ou d'horloge (S1, S2) du circuit intégré.

12. Procédé selon la revendication 11, comprenant les étapes consistant à :
- connecter le circuit intégré à un bus de données (W0-W3) et connecter un fil (W2) du bus de données à une borne (P1) de réception de la tension d'alimentation (Vdd) ou à une borne (P2, P3) de réception ou d'émission d'un signal de données ou d'horloge (S1, S2) du circuit intégré,
- appliquer la commande d'écriture au circuit intégré par l'intermédiaire du bus de données, et
- fournir la seconde tension (HV, Vpp) au circuit intégré par l'intermédiaire dudit fil (W2) du bus de données.

13. Procédé selon la revendication 12, comprenant les étapes consistant à :
- appliquer la commande d'écriture au circuit intégré au moyen d'un circuit maître (MCT) connecté au bus de données,
- détecter l'application de la commande d'écriture au moyen d'un dispositif de gestion de tension (VMCT1, VMCT2) connecté au bus de données, distinct du circuit maître (MCT) et agencé pour surveiller les données circulant sur le bus, et
- appliquer la seconde tension (HV, Vpp) audit fil (W2) du bus de données au moyen du dispositif de gestion de tension.
